Europäisches Patentamt

European Patent Office

Office européen des brevets

(11) Publication number: **0 273 556**
**A1**

## (12) EUROPEAN PATENT APPLICATION

(21) Application number: 87309841.2

(22) Date of filing: 06.11.87

(51) Int. Cl.4: **H01L 23/36** , H01L 23/14

(30) Priority: 22.12.86 US 944124

(43) Date of publication of application:
06.07.88 Bulletin 88/27

(84) Designated Contracting States:
DE FR GB IT NL SE

(71) Applicant: TRW INC.
23555 Euclid Avenue
Cleveland Ohio 44117(US)

(72) Inventor: Smolley, Robert
56 Limetree Lane
Porteuguese Bend Califotnia 90274(US)

(74) Representative: Allden, Thomas Stanley et al
A.A. THORNTON & CO. Northumberland
House 303-306 High Holborn
London WC1V 7LE(GB)

(54) Integrated-circuit chip packaging construction.

(57) An integrated-circuit (IC) chip packaging construction in which a chip package is fabricated from a material having a relatively high thermal conductivity and input/output leads are fabricated from a conductor material having a relatively low electrical resistance. The chip packaging construction includes an upper and lower cover for enclosing an IC chip and a pair of insulating frames for hermetically sealing the IC chip in the chip package. A plurality of input/output leads extend through openings in the insulating frame to make electrical connections with the IC chip. The upper and lower covers are preferably fabricated from copper or an alloy of beryllium and aluminum. The input/output leads are preferably fabricated from copper and the insulating frame is preferably fabricated from a glass-ceramic material having a coefficient of expansion approximately equal that of the upper and lower covers.

FIG. 1

## INTEGRATED-CIRCUIT CHIP PACKAGING CONSTRUCTION

### BACKGROUND OF THE INVENTION

This invention relates generally to techniques for packaging circuit elements and, more particularly, to techniques for packaging integrated-circuit (IC) chips.

Conventional integrated-circuit (IC) chip packaging techniques involve hermetically sealing the chips in individual chip packages to protect the IC chips from the surrounding environment. The chip packages are generally fabricated from a ceramic material, such as alumina ($Al_2O_3$) or beryllia (BeO). Although fabricating chip packages from one of these ceramic materials has many advantages, it does have certain disadvantages.

One disadvantage of fabricating chip packages from a ceramic material is that it must be fired at temperatures generally exceeding 1000°C. If input/output leads to the IC chip are attached to the chip package when it is fired, the input/output leads must be fabricated from a metal having a relatively high melting point. Tungsten or molybdenum, which have melting points of approximately 3380°C and 2600°C, respectively, are frequently used. However, these metals have relatively high volume resistivities, approximately 5.5 x 10$^8$ ohm-m and 5.7 x 10$^8$ ohm-m, respectively, when compared with a more conventional electrical conductor metal, such as copper, which has a volume resistivity of approximately 1.7 x 10$^8$ ohm-m. The electrical resistance (R) of a metal conductor is proportional to the metal's volume resistivity ($\rho$), as indicated by the relationship $R = \rho L/A$, where L is the length of the metal conductor and A is its cross sectional area. Although copper has a relatively low electrical resistance, it also has a relatively low melting point of approximately 1083°C. Therefore, copper cannot be used with a chip package fabricated from a ceramic material such as alumina or beryllia, which must be fired at temperatures exceeding 1000°C.

Another disadvantage of fabricating chip packages from a ceramic material such as alumina or beryllia is that these materials have relatively low thermal conductivities. Materials having low thermal conductivities cannot conduct heat away from the IC chip as readily as materials having higher thermal conductivities, thus causing higher IC chip operating temperatures.

To obviate or minimize the disadvantages associated with the use of conventional IC chip packaging techniques, it has become apparent that a new packaging approach must be employed, especially with the ever increasing size of IC chips which draw larger amounts of current and generate more heat. The new approach should preferably eliminate the need for fabricating chip packages from a material having a relatively low thermal conductivity. The new approach should also eliminate the need for fabricating chip packages from a material that must be fired at high temperatures, thus allowing for the use of input/output leads having relatively low electrical resistances. The present invention is directed to these ends.

### SUMMARY OF THE INVENTION

The present invention resides in a novel IC chip packaging construction in which a chip package is fabricated from a material having a relatively high thermal conductivity and input/output leads are fabricated from a conductor material having a relatively low electrical resistance. In a presently preferred embodiment of the invention, an IC chip is enclosed by an upper and lower metal cover and hermetically sealed by a pair of insulating frames interposed between the upper and lower metal covers. A plurality of input/output leads extend through openings in the insulating frames to make electrical connections with the IC chip. In another presently preferred embodiment of the invention, the input/output leads include metal traces that are deposited by conventional thick-film techniques on one of the insulating frames. In still another presently preferred embodiment of the invention, the upper cover is fabricated from metal or a glass-ceramic material and the lower cover is a composite cover fabricated from metal and the glass-ceramic material.

In the presently preferred embodiment of the invention, the upper and lower metal covers are fabricated from copper or an alloy of beryllium and aluminum. These materials have relatively high thermal conductivities, high resistances to corrosion, and are malleable. Consequently, a chip package fabricated from one of these materials can conduct large amounts of heat away from the IC chip, thus considerably reducing the operating temperature of the chip. Furthermore, a chip package fabricated from one of these materials can be assembled at relatively low temperatures. Therefore, the input/output leads can be fabricated from a metal having a relatively low melting point and a relatively low electrical resistance, such as copper. The insulating frame is preferably formed from a glass-ceramic material having a coefficient of expansion approximately equal that of the upper and lower metal covers. One such glass-ceramic material is disclosed in U.S. Patent 4,480,044 to McAlinn.

It will be appreciated from the foregoing that the present invention represents a significant advance over conventional IC chip packaging techniques. Other features and advantages of the present invention will become apparent from the following more detailed description, taken in conjunction with the accompanying drawings, which illustrate, by way of example, the principles of the invention.


BRIEF DESCRIPTION OF THE DRAWINGS

Figure 1 is a fragmentary perspective view of an IC chip packaging construction utilizing the technique of the present invention;

Figure 2 is an enlarged fragmentary sectional view of a presently preferred embodiment of the IC chip packaging construction;

Figures 3A-3B are enlarged fragmentary sectional views taken substantially along the line 3-3 of Figure 2; and

Figure 4 is an enlarged fragmentary sectional view of another presently preferred embodiment of the IC chip packaging construction.


DESCRIPTION OF THE PREFERRED EMBODIMENTS

As shown in the drawings for purposes of illustration, the present invention is embodied in a novel IC chip packaging construction in which a chip package is fabricated from a material having a relatively high thermal conductivity and input/output leads are fabricated from a conductor material having a relatively low electrical resistance. Conventional integrated-circuit (IC) chip packaging techniques utilize chip packages fabricated from a ceramic material, such as alumina ($Al_2O_3$) or beryllia (BeO). These ceramic materials have several disadvantages. One disadvantage is that these ceramic materials must be fired at temperatures generally exceeding 1000°C. This requires that the input/output leads be fabricated from a metal having a relatively high melting point. However, most of the available metals also have relatively high electrical resistances. Another disadvantage of fabricating chip packages from alumina or beryllia is that these materials have relatively low thermal conductivities, thus causing higher IC chip operating temperatures.

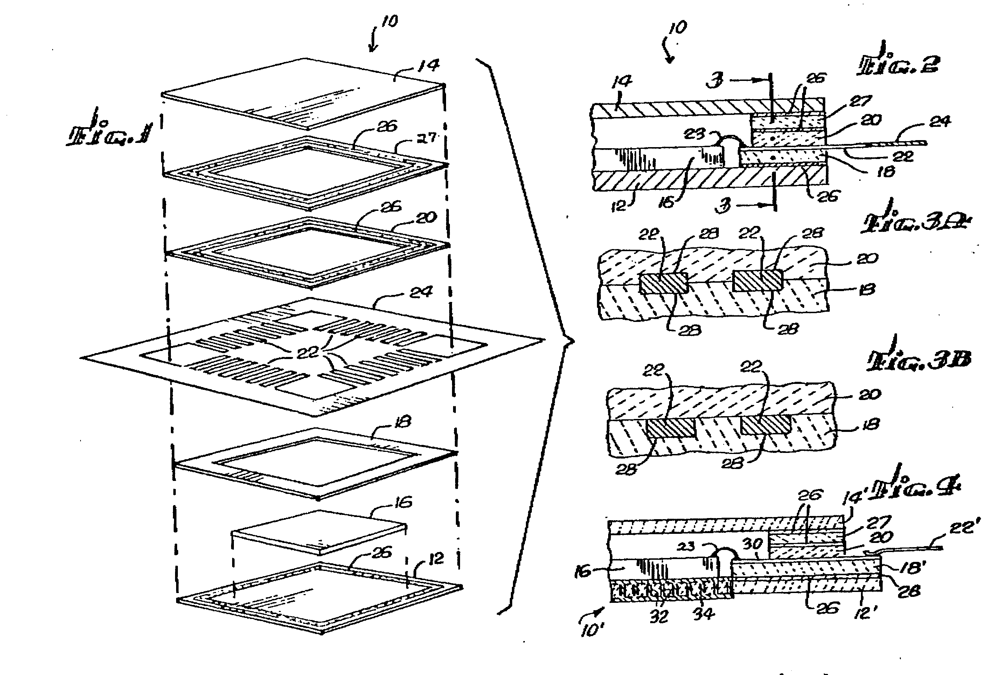

Figures 1 and 2 illustrate an IC chip packaging construction 10 utilizing the technique of the invention. The IC chip packaging construction 10 includes a lower and upper cover 12, 14, respectively, for enclosing an IC chip 16 and a pair of insulating frames 18, 20 for hermetically sealing the IC chip 16 in the chip package. A plurality of low electrical resistance input/output leads 22 make electrical connections with the IC chip 16 through fine wires 23 that are soldered to the leads 22 and to contact areas on the IC chip 16.

The chip packaging construction 10 is assembled by first sandwiching the input/output leads 22 between the two insulating frames 18, 20. The input/output leads 22 are fabricated as an integral part of a metal frame 24, which provides support and alignment for the leads 22 during this part of the assembly, but is later cut away. The insulating frame 18 is then brazed to the lower cover 12 with a brazing material 26, such as gold germanium, at a temperature not to exceed approximately 700°C. The insulating frame 20 is brazed to an attachment frame 27, also with brazing material 26. The IC chip 16 is then placed in the partially assembled package and the wires 23 are soldered between the input/output leads 22 and the chip contact areas. The upper cover 14 is placed over the partially assembled package and brazed to the attachment frame 27 with a somewhat lower temperature brazing material 26, at a temperature not to exceed approximately 300°C.

In a presently preferred embodiment of the invention, the upper and lower covers 14, 12 are metal covers fabricated preferably from copper or an alloy of beryllium and aluminum, such as Be38Al. These materials have relatively high thermal conductivities, high resistances to corrosion, and are malleable. For example, copper has a thermal conductivity of approximately 3.9 W-cm/°C-cm², at 25°C, as compared with a thermal conductivity for alumina of approximately 0.3 W-cm/°C-cm², at 25°C. Therefore, a chip package fabricated from one of these materials conducts larger amounts of heat away from the IC chip, thus considerably reducing the operating temperature of the chip.

In addition, a chip package fabricated from one of these materials can be assembled at relatively low temperatures and, therefore, the input/output leads 22 can be fabricated from a metal having a much lower melting point than the metals typically used, such as tungsten or molybdenum. Tungsten and molybdenum have melting points of approximately 3380°C and 2600°C, respectively, but relatively high volume resistivities of approximately 5.5 x 10⁸ ohm-m and 5.7 x 10⁸ ohm-m, respectively. These volume resistivities can be compared with the resistivity of a more conventional electrical conductor metal, such as copper, which has a volume resistivity of approximately 1.7 x 10⁸ ohm-m. In the presently preferred embodiment of the invention, the input/output leads 22 are fabricated from copper, which has a melting point of approximately 1083 °C. As shown in Figures 3A and 3B, the input/output leads 22 extend from the wires 23 to the exterior of the chip package through outwardly extending openings 28 in one or both of the insulating frames 18, 20.

The insulating frames 18, 20 support and insulate the input/output leads 22, while hermetically sealing the chip package. The insulating frames 18, 20 should preferably be fabricated from a glass-ceramic material with a coefficient of expansion that is approximately equal to that of the upper and lower metal covers 14, 12. Copper has a coefficient of expansion of approximately $170 \times 10^7/°C$, from 0 to 100°C, and an alloy of beryllium and aluminum has a coefficient of expansion that depends on the relative proportions of each metal, but will fall within a range between the coefficients for the two metals, which are approximately $120 \times 10^7$ and $235 \times 10^7/°C$, from 0 to 100°C, respectively. In the presently preferred embodiment of the invention, the insulating frames 18, 20 are fabricated from the glass-ceramic material disclosed in U.S. Patent 4,480,044 to McAlinn, which is incorporated herein by reference. The glass-ceramic material disclosed by this patent has an adjustable coefficient of expansion ranging from approximately 120 to $160 \times 10^7/°C$, depending on the intensity and time of exposure of a precursor glass composition to ultraviolet radiation and the temperature and time of subsequent heat treatments to the radiated precursor glass composition. The precursor glass composition is disclosed in U.S. Patent 2,971,853 and is manufactured by the Corning Glass Works, Corning, New York, and marketed under the trademark FOTOCERAM®.

In another presently preferred embodiment of the invention, as shown in Figure 4, the input/output leads include metal traces 30 that are deposited by conventional thick-film techniques on one of the insulating frames and input/output leads 22' that are soldered to the outer ends of the thick-film traces 30. In this presently preferred embodiment of the invention, the metal traces 30 are preferably fabricated from copper.

In still another presently preferred embodiment of the invention, also as shown in Figure 4, an IC chip packaging construction 10' includes an upper cover 14' that is fabricated from metal or the glass-ceramic material and a lower composite cover 12' that is fabricated from the glass-ceramic material, with a plurality of through-holes 32 in the glass-ceramic material being filled with a metal 34, such as copper. The composite cover has less weight and a more level surface and is less costly than the all metal cover.

From the foregoing, it will be appreciated that the present invention represents a significant advance over conventional IC chip packaging techniques. Although several preferred embodiments of the invention have been shown and described, it will be apparent that other adaptations and modifications can be made without departing from the spirit and scope of the invention. Accordingly, the invention is not to be limited, except as by the following claims.

## Claims

1. An integrated-circuit (IC) chip package, comprising:
an upper cover for enclosing an IC chip;
a lower cover for enclosing the IC chip;
an insulating frame interposed between the upper and lower covers for hermetically sealing the IC chip in the chip package, the insulating frame having a plurality of outwardly extending openings;
a plurality of input/output leads extending through the openings in the insulating frame for making electrical connections with the IC chip;
wherein the upper and lower covers are fabricated from a material having a high thermal conductivity and the plurality of input/output leads are fabricated from a conductor material having a low electrical resistance.

2. The chip package as set forth in claim 1, wherein at least one of the covers is fabricated from a material that is electrically conductive and the insulating frame is fabricated from a material that is electrically insulative.

3. The chip package as set forth in claim 1, wherein the insulating frame is fabricated from a glass-ceramic material having approximately the same coefficient of expansion as the upper and lower covers.

4. The chip package as set forth in claim 1, wherein the upper and lower covers are fabricated from copper.

5. The chip package as set forth in claim 1, wherein the upper and lower covers are fabricated from an alloy of beryllium and aluminum.

6. The chip package as set forth in claim 1, wherein the plurality of input/output leads are fabricated from copper.

7. The chip package as set forth in claim 1, wherein the insulating frame includes two insulating frames with the plurality of input/output leads interposed between the insulating frames.

8. The chip package as set forth in claim 7, wherein the plurality of input/output leads include metal traces deposited on one of the insulating frames.

9. The chip package as set forth in claim 1, wherein the upper and lower covers and the insulating frame are fabricated from a glass-ceramic material, the lower cover having a plurality of through-holes filled with a material having a high thermal conductivity.

10. The chip package as set forth in claim 9, wherein the through-holes are filled with copper.

11. A method for constructing an integrated-circuit (IC) chip package, comprising the steps of: enclosing an IC chip in a chip package fabricated from a material having a high thermal conductivity, the chip package having an upper and a lower cover;

sealing the chip package with an insulating frame interposed between the upper and lower covers, the insulating frame having a plurality of outwardly extending openings; and

electrically connecting the IC chip with a plurality of input/output leads fabricated from a conductor material having a low electrical resistance, the input/output leads extending through the openings in the insulating frame.

12. The method as set forth in claim 11, wherein at least one of the covers is fabricated from la material that is electrically conductive and the insulating frame is fabricated from a material that is electrically insulative.

13. The method as set forth in claim 11, wherein the insulating frame is fabricated from a glass-ceramic material having approximately the same coefficient of expansion as the chip package.

14. The method as set forth in claim 11, wherein the upper and lower covers are fabricated from copper.

15. The method as set forth in claim 11, wherein the upper and lower covers are fabricated from an alloy of beryllium and aluminum.

16. The method as set forth in claim 11, wherein the plurality of input/output leads are fabricated from copper.

17. The method as set forth in claim 11, wherein the insulating frame includes two insulating frames with the plurality of input/output leads interposed between the insulating frames.

18. The method as set forth in claim 17, wherein the plurality of input/output leads include metal traces deposited on one of the insulating frames.

19. The method as set forth in claim 11, wherein the step of sealing the chip package includes the steps of:

positioning the plurality of input/output leads in the openings in the insulating frame, the input/output leads being attached to the inside edges of a metal frame;

sealing the chip package with the insulating frame; and

cutting away the metal frame.

20. The method as set forth in claim 19, wherein the plurality of input/output leads and the metal frame are fabricated from copper.

21. The method as set forth in claim 11, wherein the upper and lower covers and the insulating frame are fabricated from a glass-ceramic material, the lower cover having a plurality of through-holes filled with a material having a high thermal conductivity.

22. The method as set forth in claim 21, wherein the through-holes are filled with copper.

FIG. 1

FIG. 2

FIG. 3A

FIG. 3B

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 164 794 (MONOLITHIC MEMORIES INC.)<br>* figures 1, 2; page 2, paragraph 2; page 3, lines 25-29; page 4, line 5; figure 4 * | 1,2,4-6,11,12,14-16,20 | H 01 L 23/36<br>H 01 L 23/14 |
| Y | | 3,8-10,13,18,21,22 | |
| Y | EP-A-0 121 374 (ERA PATENTS LTD.)<br>* page 2, lines 6-10; page 8, lines 14-21; page 10, lines 16-20; figure 4, abstract * | 3,13 | |
| Y | PATENT ABSTRACTS OF JAPAN, vol. 6, no. 77 (E-106)[955], 14th May 1982; & JP - A - 57 17150 (NIPPON DENKI K.K.) 28-01-1982<br>* abstract, figure * | 8,18 | |
| Y | EP-A-0 055 578 (HONEYWELL)<br>* abstract; figure 1, claim 2 * | 9,10,21,22 | TECHNICAL FIELDS SEARCHED (Int. Cl.4) |
| A | US-A-4 256 792 (KOEPKE et al.)<br>* abstract; figure 1a * | 9,21 | H 01 L |
| A | EP-A-0 157 685 (ISOTRONICS, INC.)<br>* figure 2, page 6, lines 31-35 * | 19 | |
| D,A | US-A-4 480 044 (McALINN)<br>* whole document * | | |

The present search report has been drawn up for all claims

| Place of search | Date of completion of the search | Examiner |
|---|---|---|
| BERLIN | 01-02-1988 | JUHL A. |